Europäisches Patentamt

European Patent Office

Office européen des brevets

(19)

(11) Publication number: **0 125 098**
A1

(12)

# EUROPEAN PATENT APPLICATION

(21) Application number: **84302949.7**

(22) Date of filing: **02.05.84**

(51) Int. Cl.³: **H 01 R 9/09**
**H 01 R 43/10**

(30) Priority: **03.05.83 GB 8312011**

(43) Date of publication of application:
**14.11.84 Bulletin 84/46**

(84) Designated Contracting States:
**AT BE CH DE FR IT LI LU NL SE**

(71) Applicant: **BICC Public Limited Company**
**21, Bloomsbury Street**
**London, WC1B 3QN(GB)**

(72) Inventor: **Lee, David**
**9, Whitlow Avenue**
**Golborne Warrington Cheshire(GB)**

(74) Representative: **Denton, Michael John**
**BICC plc Patents and Licensing Department 38 Ariel Way**
**Wood Lane**
**London W12 7DX(GB)**

(54) A method of forming electrically conductive pins.

(57) A method of forming electrically conductive pins for printed circuit boards from strip or sheet metal or metal alloy comprises the following steps:-

(a) shearing the strip or sheet to form a carrier strip (1) and pin profiles (2), each pin profile having a defined portion (3) for becoming the compliant section of the pin, and each profile being attached to the carrier strip;

(b) coining the defined portion of each pin to increase its surface area; and

(c) folding the defined portion of each pin to form the required cross-sectional shape of the compliant section.

Fig. 1.

EP 0 125 098 A1

**0125098**
GJB/8312011

## A METHOD OF FORMING ELECTRICALLY CONDUCTIVE PINS

This invention relates to a method of forming electrically conductive pins for printed circuit boards, and particularly, though not exclusively, pins for making a solderless connection to the conductive rails on the board.

Pins are used to electrically connect components or connectors to the conductive rails. In one known arrangement of printed circuit board, each hole through the board has a surface layer of metal or metal alloy which is directly connected to a conductive rail on the board. Connection between a rail and a pin is made by pushing a pin into the hole, the pin's size and cross-sectional shape being such that a portion of the pin is compliant and has a cross-sectional shape which is distorted to engage, and electrically connect with, the surface layer of the hole, and hence the conductive rail. It is known to manufacture such pins from metal bar or wire stock, for example as shown in GB 1470007. This can constrain the design of compliant section regarding material required and can be costly in terms of machinery large enough to perform the required operations on the metal bar.

According to the present invention a method of forming electrically conductive pins for printed circuit boards from strip or sheet metal or metal alloy comprises the following steps:-

(a) shearing the strip or sheet to form a carrier strip and pin profiles, each pin profile having a defined portion for becoming the compliant section of the pin, and each profile being attached to the carrier strip;

(b) coining the defined portion of each pin to increase its surface area; and

(c) folding the defined portion of each pin to form the required cross-sectional shape of the compliant section.

Preferably the defined portion of each pin is folded into a substantially C-shaped cross-section. In this case a slot is preferably cut in the defined portion between Steps (b) and (c), the slot extending in the longitudinal direction of the pin. Preferably the slot is centrally positioned in the defined portion. Alternatively the defined portion may be folded into a substantially S-shaped cross-section.

The pins may be sold attached to the carrier strip or individually or placed in a connector housing.

Preferably each pin is formed with the compliant section positioned between two longitudinally extending posts. The posts are preferably defined by cut flat portions of the strip or sheet formed during Step (a) which extend away from the defined portion. In this case, the posts will have a substantially rectangular cross-section. Alternatively, however, the cut flat portions may be folded round so the posts have a substantially circular cross-section. The folding of the posts is preferably carried out during Step (c).

Alternatively the compliant section may be positioned between a post and an electric contact which is either capable of electrically connecting with an electrical conductor (for example an insulation displacement contact or a crimpable ferrule) or capable of mating with a corresponding electric contact (for example a spring contact). In this case the profile of the contacts is preferably formed during Step (a), and the contacts are preferably folded into the required shape during Step (c) if required.

Each pin is preferably formed with an enlarged section adjacent the defined portion of each pin, the enlarged section being formed during Step (a). The enlarged section can be used either to retain each pin in a connector housing of insulating material from which the pin (including the compliant section) projects, or to prevent over insertion of each pin in a hole in the printed circuit board. Preferably the enlarged section is substantially rectangular.

Preferably the sheet is of high strength copper alloy.

The invention also includes electrically conductive pins made by the method herein described.

Using this invention pins can be made at a reduced cost from previously known methods.

Although the pins are designed to make a solderless connection with a printed circuit board, they can, if required, also be soldered in position.

The invention will now be further described, by way of example only, with reference to the accompanying drawings, in which:-

Figures 1 to 4 show the stepped formation of electrically conductive pins in accordance with the invention;

Figure 5 is a side view of an alternative electrically conductive pin made in accordance with the invention; and

Figure 6 is a cross-sectional view along the line W-W of the electrically conductive pin shown in Figure 5.

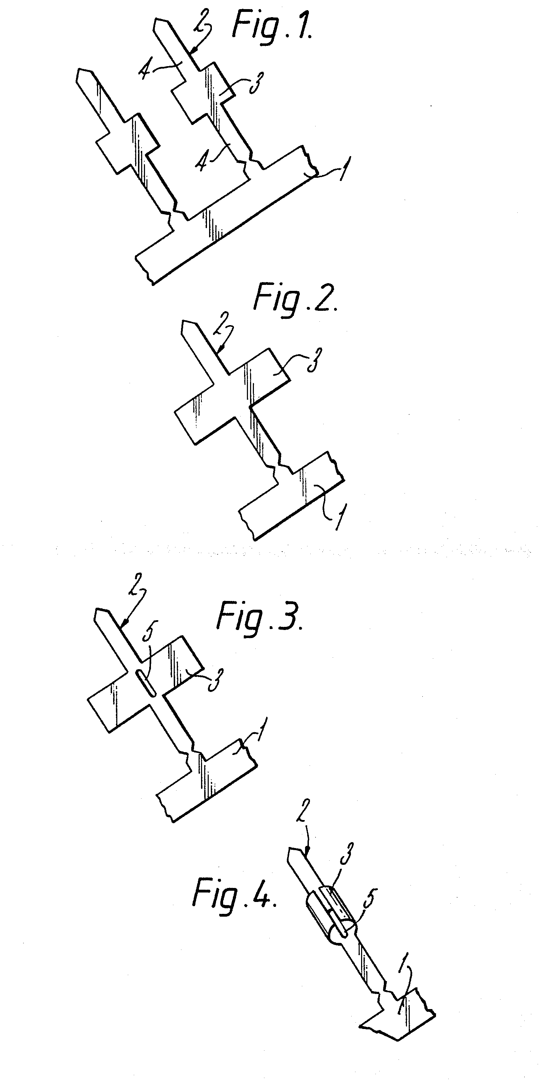

A continuous sheet of high strength copper alloy is sheared to form, as shown in Figure 1, a carrier strip 1 and a series of pin profiles 2 each having a defined portion 3 positioned between two longitudinally extending posts 4, each having a substantially rectangular cross-section.

The defined portion 3 of each pin profile is then coined to enlarge the surface area of the defined portion, as shown in Figure 2.

A slot 5, as shown in Figure 3, is then cut into the enlarged defined portion 3 such that it is centrally positioned in the defined portion and extends longitudinally with the axis of the pin profile 2. The defined portion 3 of each pin profile is then folded into a substantially C-shaped cross-section, as shown in Figure 4, to form the compliant section.

Each pin is separated from the carrier strip 1 by a shearing machine. The separated carrier strip is collected and recycled.

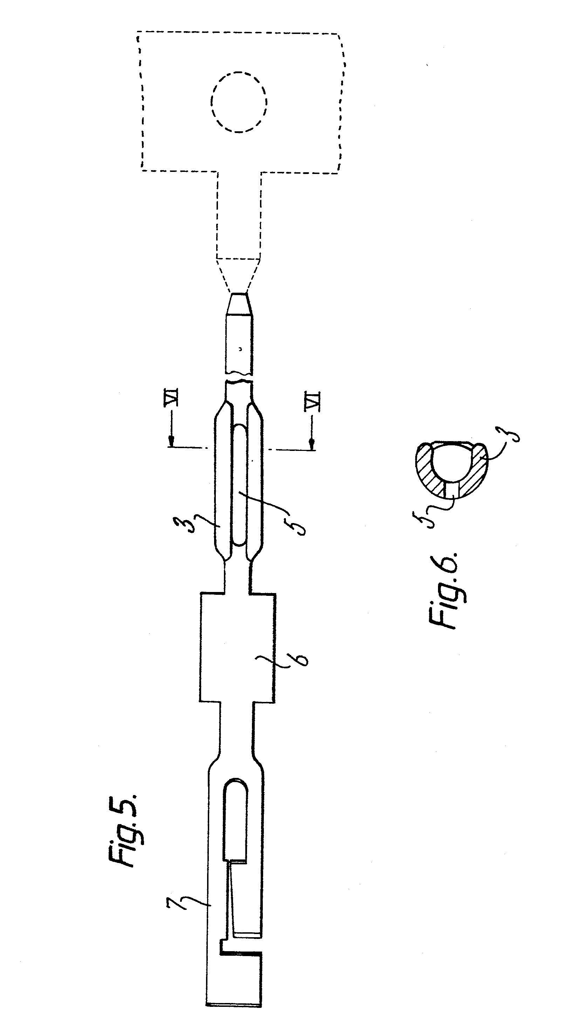

Figures 5 and 6 show an alternative embodiment of an electrically conductive pin comprising a folded defined portion 3 having a C-shaped cross-section and slit 5 which form the compliant section; a rectangular enlarged section 6 adjacent the compliant section formed during the initial shearing of the copper sheet and which is used either to retain the pin in a connector housing of insulating material from which the pin (including the compliant section) projects, or to prevent over insertion of the pin in a hole in a printed circuit board; and an electrical connector 7 in the shape of a spring contact which is capable of mating with an electrically conductive pin.

CLAIMS

1.     A method of forming electrically conductive pins for printed circuit boards from strip or sheet metal or metal alloy comprises the following steps:-

(a) shearing the strip or sheet to form a carrier strip (1) and pin profiles (2), each pin profile having a defined portion (3) for becoming the compliant section of the pin, and each profile being attached to the carrier strip;

(b) coining the defined portion of each pin to increase its surface area; and

(c) folding the defined portion of each pin to form the required cross-sectional shape of the compliant section.

2.     A method of forming electrically conductive pins as claimed in Claim 1, wherein the defined portion of each pin is folded into a substantially C-shaped cross-section.

3.     A method of forming electrically conductive pins as claimed in Claim 2, wherein a slot (5) is cut in the defined portion and extends in the longitudinal direction of the pin.

4.     A method of forming electrically conductive pins as claimed in Claim 1, wherein the defined portion is folded into a substantially S-shaped cross-section.

5.     A method of forming electrically conductive pins as claimed in any one of Claims 1 to 4, wherein each pin is formed with the compliant section positioned between two longitudinally extending posts (4).

6. A method of forming electrically conductive pins as claimed in any one of Claims 1 to 5, wherein at least one post is folded round to have a substantially circular cross-section.

7. A method of forming electrically conductive pins as claimed in any one of Claims 1 to 4, wherein each pin is formed with the compliant section positioned between a post and an electric contact (7).

8. A method of forming electrically conductive pins as claimed in Claim 7, wherein the electric contact is formed whilst each pin is attached to the carrier strip.

9. A method of forming electrically conductive pins as claimed in any one of Claims 1 to 8, wherein each pin is formed with an enlarged section (6) adjacent the defined portion.

10. Electrically conductive pins for printed circuit boards made by a method as claimed in any one of Claims 1 to 9.

Fig.1.

Fig.2.

Fig.3.

Fig.4.

Fig.5.

7

3

6

5

VI

VI

Fig.6.

5

3

# EUROPEAN SEARCH REPORT

European Patent Office

## DOCUMENTS CONSIDERED TO BE RELEVANT

| Category | Citation of document with indication where appropriate, of relevant passages | Relevant to claim | CLASSIFICATION OF THE APPLICATION (Int. Cl. ³) |
|---|---|---|---|
| X,Y | US-A-4 274 699  (DU PONT)  * Figures  2,7;  column 3, lines 6-35 * | 1-3,7-10 | H 01 R  9/09 H 01 R  43/00 |
| Y | GB-A-1 149 332  (AMP)  * Figures  1-4,9;  page 2, lines 46-114 * | 1-3,5 10 | |
| A | US-A-4 223 970  (ELECTRONICS STAMPING CORP.)  * Figures  1,3,4; column 3, line 44 - column 4, line 28 * | 1,4,7 8,10 | |
| A | US-A-4 045 868  (ELFAB CORP.)  * Figures 1-5; column 7, line 7 - column 8, line 10 * | 1,7-10 | |
| A | US-A-3 997 237  (DU PONT)  * Figures 1,2; column 2, line 26 - column 3, line 17 * | 1,3,7 10 | TECHNICAL FIELDS SEARCHED (Int. Cl. ³)  H 01 R  9/00 H 01 R  43/00 |
| A | US-A-3 864 014  (AMP)  * Figures 1A,2; column 4, line 40 - column 5,  line 16; column 6, lines 30-47 * | 1,7,8 10 | |

--- -/-

The present search report has been drawn up for all claims

| Place of search | Date of completion of the search | Examiner |
|---|---|---|
| THE HAGUE | 30-07-1984 | WAERN G.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl. ³) |
|---|---|---|---|
| A | US-A-4 381 134  (BELL TELEPHONE)<br><br>* Figure 2; column 3, line 57 - column 4, line 21; column 4, lines 53-57 * | 1,2,5,<br>9,10 | |

-----

TECHNICAL FIELDS
SEARCHED (Int. Cl. ³)

The present search report has been drawn up for all claims

| Place of search | Date of completion of the search | Examiner |
|---|---|---|
| THE HAGUE | 30-07-1984 | WAERN G.M. |